# EUROPEAN PATENT SPECIFICATION

(11) **EP 2 972 432 B1**
(45) Date of publication and mention of the grant of the patent: **12.08.2020**
(21) Application number: 14778114.0
(22) Date of filing: 12.03.2014
(51) Int. Cl.: G01R 31/34

(54) **ALTERNATOR AND STARTER TESTER WITH CAPACITIVE ELEMENT, ACTIVE LOAD CONTROL AND BELT SLIP DETECTION**
WECHSELSTROMGENERATOR UND ANLASSERTESTVORRICHTUNG MIT KAPAZITIVEN ELEMENTEN, AKTIVER LADESTEUERUNG UND TREIBRIEMENSCHLUPFERKENNUNG
TESTEUR D'ALTERNATEUR ET DE DÉMARREUR DOTÉ D'UN ÉLÉMENT CAPACITIF, COMMANDE DE CHARGE ACTIVE ET DÉTECTION DE GLISSEMENT DE COURROIE

(30) Priority: 12.03.2013 US 201313797088; 14.03.2013 US 201313826172; 15.03.2013 US 201361791438 P
(43) Date of publication of application: 20.01.2016
(73) Proprietor: Bosch Automotive Service Solutions Inc., Warren, Michigan 48092 (US); Robert Bosch GmbH, 70442 Stuttgart (DE)
(72) Inventor: CHINNADURAI, Manokar, Owatonna, Minnesota 55060 (US); MILLER, Garret, Owatonna, Minnesota 55060 (US)
(74) Representative: Isarpatent
(86) International application number: PCT/US2014/024584
(87) International publication number: WO 2014/165156

(56) References cited:
- US-A1- 2004 108 855
- US-A1- 2007 152 702
- US-A1- 2009 140 575
- US-A1- 2010 106 361
- US-A1- 2010 170 944
- US-A1- 2010 170 944
- US-A1- 2011 288 789
- US-A1- 2012 035 800
- US-A1- 2012 323 435
- US-A1- 2013 031 318

## Description

### FIELD OF THE DISCLOSURE

The present invention pertains to the field of testing vehicle motor rotary accessory devices. More particularly, the present invention relates to devices for testing alternators or starter motors wherein the devices include a capacitive element, and having an active load control circuitry. The invention also relates to a device for the more accurate testing of the alternator of a motor vehicle engine or the like.

### BACKGROUND OF THE DISCLOSURE

It is well known in the vehicle industry that certain rotary accessory devices are often used in connection with vehicle motors. Two such accessory devices are alternators and starter motors. Alternators are used in connection with an engine and are typically belt driven by the engine. Alternators have internal components, which when rotated supply electrical power to a vehicle battery. Alternators are typically removable but rigidly mounted via a bracket to the engine block or the chassis of the vehicle. In many cases, where a standard type of alternating mounting arrangement is used, the alternator has "ears" with holes that are mounted onto a post or bolt attached to the vehicle. This permits pivoting of the alternator so that the alternator can be pivoted around the post against the belt tension in order to install and remove belts, and provide a suitable tension when the belt is installed.

Starter motors are electrical motors, which are typically removable but rigidly mounted to an engine or transmission casing. The starter motor has an electrically driven pinion gear extending from the starter motor that engages a component (typically gears on the flywheel of the engine) in order to be able to rotate the crankshaft of the engine to start it. There is a wide range of attachment mechanisms for attaching the described starter motor.

Conventional alternator and starter tester may test alternators and/or starter motors using a direct current (DC) power source. For example, the DC power source may be used to power the starter motor and bias the alternator during a testing process. The DC power source may determine the capability of an alternator and starter tester. Oftentimes, the alternator and starter tester requires high power in order to achieve desired accuracy when testing the starter motor or the alternator. The high power required leads to expensive and bulky circuit components which in turn lead to higher cost, size and weight for the alternator and starter tester. Additionally, the high power demand required by the prior art systems resulted in greater power consumption and operating costs. Thus, it would be desirable to have an alternator or starter tester with high accuracy with decreased cost, size and weight.

Oftentimes, the alternator and starter tester has limited capabilities because of the available power supply. The maximum rating of the alternator and starter tester is determined by the available power supply and an efficiency of the tested equipment. However, the tested equipment may have different efficiencies or be defective and may lead to tripping of the available power supply protection. Thus, it would be desirable to have an alternator or starter tester with active load control circuitry to monitor an input power level.

It is well known in the vehicle industry to employ analytical tools in connection with the analysis of vehicle motors and their individual components and systems. Alternators have internal components, which when rotated supply electrical power to a vehicle and/or an engine.

It is often desirable to test alternators after removal from a vehicle at a parts supply sales location, at a repair facility or the like. For example, such testing may be desirable for an existing alternator motor before installing a new alternator. In the event that the existing alternator may pass the test, a user may eliminate that the alternator as the cause of a problem with the vehicle.

Alternator test equipment typically utilizes a motor as prime mover for rotating the alternator under test and the alternator is coupled to the prime mover through a belt for power transmission. During the test procedure, the prime mover rotates the alternator under test and applies known loads on the alternator, measures the output and checks the ability of the alternator to generate power at a particular current and voltage.

One of the assumptions during the test regarding the test equipment is that there is no loss or a minimum power transmission loss, which will not affect the test results of the alternator. This assumption is not valid and it may lead to failing a good alternator due to transmission belt slippage. In this regard, the drive belt may slip and accordingly not rotate the alternator as desired. This may result in an indication that the alternator is not properly functioning.
U.S. Patent Publication no. 2012/323 435 discloses a parasitic drain tester that measures a parasitic battery drain. A current measuring circuit includes a capacitor smoothing the current distribution within the circuit, a first interface connected to a vehicle power source and the capacitor, a second interface accommodating an outside connection for communication, a first processor connected to the second interface and the capacitor, the processor communicating with the second interface and performing analysis and calculation of the data received, and a converting unit connected to the processor, converting the signal received through the first interface from a first form to a second form.; The first unit is connected to the current measuring circuit, and includes a memory storing information retrieved from the current measuring circuit through the second interface, and a second processor analyzing the information received from the current measuring circuit and providing instructions to the first processor through the second interface.
U.S. Patent Publication no. 2010/170 944 discloses an alternator and starter tester system having a bar code reader. The bar code can contain information regarding the component being tested and can direct the tester to conduct the appropriate test. The bar code can also encode the results of the test on a second bar code. The second bar code can then be coupled to the tested component.
U.S. Patent Publication no. 2009/140 575 discloses a secondary power source system, includes a first unit receiving a primary power input and restricting a current used for charging to a predetermined amount, a second unit including a device providing capacitance, receiving a first output from the first unit with restricted current, a third unit generating a second output of a certain voltage, and a fourth unit performing a logical OR operation with the primary power input, first output from the first unit and second output from the second unit, to generate a single third output of a certain voltage.

Thus, a need exists for determining whether the test equipment is properly operating before and/or during testing of the alternator so that the alternator function may be properly determined.

### SUMMARY OF THE DISCLOSURE

The foregoing needs are met, to a great extent, by the present disclosure, wherein in one aspect, an apparatus is provided that in some embodiments an alternator and starter motor tester includes a capacitive element. The capacitive elements may provide an additional source of power that may allow for the use of smaller and less costly circuit components in the starter motor tester. The smaller and less costly circuit components may have reduced power consumption. Finally, the capacitive elements may be sufficiently charged by the smaller circuit components when the starter motor tester is not being utilized. Further, an apparatus is provided that in some embodiments an alternator and starter motor tester includes a power supply monitor and determines whether the alternator under test is being properly driven to ensure more accurate test results.

In accordance with claim 1 of the present disclosure, a diagnostic system configured to test a performance of a vehicle component may include a processor configured to process test information from the vehicle component and control the vehicle component to be tested. The diagnostic system may also include a memory configured to store the test information of the vehicle component and software that operates the vehicle component and a capacitive element configured to supply power to perform the testing of the vehicle component, wherein the memory and the capacitive element are in communication with the processor. The diagnostic system may also include a charging module that controls a timing and an amount of charge provided to the capacitive element, the charging module charging the capacitive element based at least in part on an amount of power required to perform the testing of the vehicle component.
In accordance with claim 10 of the present disclosure, a method of testing of a vehicle component may include receiving, via an input device, a selection of the vehicle component for the testing and identifying, via an interface module, information associated with the vehicle component. The method may also include charging, via a charging module, a capacitive element based at least in part on the information associated with the vehicle component in order to perform the testing of the vehicle component. The method may also include controlling, via the charging module, a timing and an amount of charge provided to the capacitive element, wherein the charging module charges the capacitive element based at least in part on an amount of power required to perform the testing of the vehicle component.

In accordance with yet another embodiment of the present disclosure is a diagnostic system configured to test a performance of a vehicle component may include an electrical connection for coupling the diagnostic tool to an external power source and a power supply circuitry for processing power received from the external power source. The diagnostic system may also include a test and control circuitry for controlling the testing of the vehicle component and a capacitive element for receiving processed power from the power supply circuitry to power the testing of the vehicle component.

In accordance with still another embodiment of the present disclosure, a diagnostic system configured to testing the performance of a vehicle component is provided. The diagnostic system may include a processor configured to process test information from the vehicle component and control the vehicle component to be tested. Also, the diagnostic system may include a memory configured to store the test information of the vehicle component and software that operates the vehicle component. Further, the diagnostic system may include a monitoring module configured to monitor a power supply provided to perform the testing of the vehicle component, wherein if the monitored power supply exceeds a predetermined threshold, then the monitoring module cuts off the power supply and wherein the memory and the monitoring module are in communication with the processor.

In accordance with another embodiment of the present disclosure, a method of testing a vehicle component is provided. The method may include receiving, via an input device, a selection of the vehicle component for the testing. The method may also include identifying, via an interface module, information associated with the vehicle component. The method may further include monitoring, via a monitoring module, a power supply provided to perform the testing of the vehicle component, determining if the power supply exceeds a predetermined threshold, and terminating connection of the power supply if the power supply was determined to exceed the predetermined threshold.

In still another embodiment, a diagnostic tester configured to test a performance of a vehicle component and includes a processor configured to process test information from the vehicle component and control the vehicle component to be tested, a memory configured to store a database information of the vehicle component and software that operates the vehicle component; a power lead configured to provide a power supply to perform the testing of the vehicle component, and a monitoring module configured to monitor the power supply, wherein if the monitored power supply exceeds a predetermined threshold, then the monitoring module cuts off the power supply using a circuit breaker system in the tester and wherein the memory and the monitoring module are in communication with the processor.

In an exemplary aspect, a diagnostic tool for testing the performance of a component of a vehicle is provided and can include a processor that can process test information from an alternator component of the vehicle and can control and activate the alternator component during an alternator test; a memory that can store the test information of the alternator component and software that can operate the alternator component of the vehicle, a motor having a pulley that can connect to the alternator, a first load component that can be controlled by the processor to put a first load on the alternator during testing, and an analog to digital converter (ADC) that can provide an output voltage of the alternator, wherein the processor determines a ripple frequency from the output voltage.

In another embodiment, a method of testing an alternator can include the steps of starting an alternator drive motor with a processor of an alternator tester, receiving a voltage output from an analog to digital converter with the processor, determining a first ripple frequency from the voltage output with the processor, determining a second ripple frequency after a first load is applied by a first load component that is controlled by the processor, calculating a first difference between the first and second ripple frequencies by the processor, and determining if the first difference exceeds a predetermined percentage by the processor.

In still another embodiment, a diagnostic tool for testing the performance of a component of a vehicle is provided and can include a processor that can process test information from an alternator component of the vehicle and can control and activate the alternator component during an alternator test, a memory that can store the test information of the alternator component and software that operates the alternator component of the vehicle, a motor that can drive the alternator during the test, a power supply that can supply power to the motor during testing, a first load component that can be controlled by the processor, wherein the first load can apply a first load on the alternator during testing, and an analog to digital converter (ADC) that can provide an output voltage of the alternator, wherein the processor determines a ripple frequency from the output voltage.

### BRIEF DESCRIPTION OF THE DRAWINGS

FIG. 1 is a perspective view of an alternator and starter motor tester according to an exemplary embodiment of the present invention.
FIG. 2 is a perspective view of the alternator and starter motor tester according to an exemplary embodiment of the present invention.
FIG. 3 is a block diagram of the main components of the alternator and starter motor tester according to an exemplary embodiment of the present invention.
FIG. 4 illustrates a method for charging an alternator and starter motor tester according to an exemplary embodiment of the present invention.
FIG. 5 is a perspective view of the peripheral and remote connections of the alternator and starter motor tester according to an exemplary embodiment of the present invention.
FIG. 6 illustrates a circuit schematic diagram of the alternator and starter motor tester according to an exemplary embodiment of the present invention.
FIG. 7 is a block diagram of the main components of the alternator and starter motor tester according to an exemplary embodiment of the present disclosure.
FIG. 8 illustrates a method for monitoring an input power level of an alternator and starter motor tester according to an exemplary embodiment of the present disclosure.
FIG. 9 illustrates a circuit schematic diagram of the alternator and starter motor tester according to an exemplary embodiment of the present disclosure.
FIG. 10 is a perspective view of an alternator tester according to an aspect of the invention.
FIG. 11 is a block diagram of the components of the alternator and starter motor tester according to an aspect of the invention.
FIG. 12 is a block diagram of the alternator test system with belt slip detection in accordance with an aspect of the invention.
FIG. 13 is a process flow diagram of the belt slip system in accordance with an aspect of the invention.
FIG. 14 is a schematic of the ripple frequency measurement device in accordance with an aspect of the invention.

### DETAILED DESCRIPTION

The present invention will now be described with reference to the drawing figures, in which like reference numerals refer to like parts throughout. An embodiment in accordance with the present invention provides an alternator and starter motor tester for holding and testing an alternator or starter motor. The alternator and starter motor tester includes a protective hood or cover, a controller connecting an LCD touch-screen, a barcode connector, USB host and USB function connectors, an Ethernet connector, and a flash memory connector. An aspect in accordance with the present disclosure provides an alternator tester for testing an alternator that includes a device for more accurate testing of the alternator of a motor vehicle engine or the like.

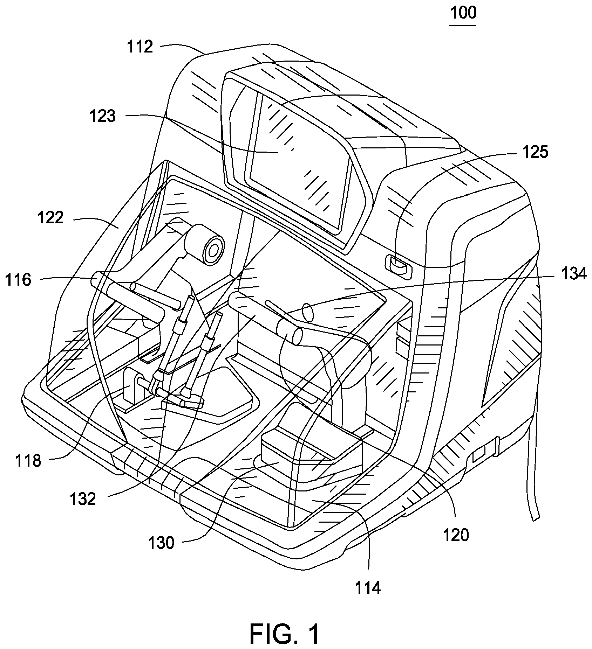

An embodiment of the testing apparatus is illustrated in FIG. 1. FIG. 1 illustrates an alternator and starter motor tester 100 ("tester") including a housing 112 and a base plate (or chassis) 114. The housing 112 surrounds and supports various operative components of the tester 100 including, for example, a power supply, diagnostic electronics, mounting devices, a monitor screen 123, a protective door cover 122, and the like. In one embodiment, the monitor screen 123, *e.g*., LCD touch-screen, may be disposed within the housing 112. A test power button 125, such as a toggle-switch, is provided on the housing 112 to activate and de-activate test power to the drive motor (not shown) and/or the transformer (not shown). A main power switch (not shown) is also used to provide power to the tester 100.

The tester 100 also includes an alternator belt tensioning arrangement generally designated 116, an alternator mounting arrangement generally designated 118, and a starter motor holder arrangement generally designated as 120. Each of the belt tensioning arrangement 116, the alternator mounting arrangement 118, and the starter motor holder arrangement 120 may be mounted directly to the base plate 114.

The alternator belt tensioning arrangement 116 and the alternator mounting arrangement 118 together hold the alternator in place for testing. An installation assembly that includes one or more mounting pins (not shown) can be placed in the alternator mounting arrangement 118 in order to mount the alternator. The alternator can be horizontally or vertically mounted depending on the type of alternator. The pins are replaceable to allow flexibility for current and future applications.

Additionally, a drive belt (not shown), such as a serpentine or V-type belt or the like, can be connected to the alternator and the drive motor to simulate the operating environment in the vehicle. A gas piston may be used for belt tension to ensure consistent belt tension during testing, thereby eliminating over tensioning or belt slippage that may affect test results.

The starter motor holder arrangement 120 includes a quick release ratchet system, wherein the starter is placed on a pad and held in place by the ratchet system. The starter motor holder arrangement 120 includes, a support pad 130, a handle 132 and a release lock 134 that when operated engages and disengages a lock (pawl, for example) from a ratchet (both not shown). The starter motor holder arrangement 120 helps to eliminate the use of straps, and alternatively uses the quick ratchet to hold the starter without the need of any additional holding mechanism or end user assistance during the test. Thus, the aforementioned arrangement makes the loading and unloading of components to be tested much more efficient. The starter motor may be placed on the support pad 130 for testing. Upon the placement, the operator squeezes the release lock 134 and presses down on the handle 132 to engage the starter motor and then releases the lock so that the lock is again reengaged. The starter motor may be powered by a transformer (not shown) in order to simulate operating environments. The transformer may be powered by an external power source and may provide test power to the starter motor via a heavy duty cable and clamps.

FIG. 1 also illustrates the monitor screen 123 that can operate as a touch-screen LCD user interface that communicates with a controller (discussed below) as well as to display information to the end user. The present invention also utilizes an on-line tutorial for quickly training new personnel on the unit's functionality and on-line help screens to help new users navigate and test components during a test. The monitor screen 123 may offer step-by-step instructions for setting up the tester 100 and conducting tests. The monitor screen 123 may also display on-screen hook up diagrams and a specification library database, which eliminate the need for paper flipcharts and enables software updates for new alternator applications or starter configurations. This database can be updated by compact flash, flash drive, other memory media or remotely via a network connection (discussed below). The monitor screen 123 may allow end users to run advertising screens when the tester is not in use. These screens can be uploaded to the tester 100 from an end user's network server or uploaded from a compact flash or other memory media. Additionally, the monitor screen 123 may be capable of displaying information in various updatable languages.

The tester 100 may output "Good/Bad" or "Pass/Fail" results to the end user. An end user printout that details test results and provides technical advice for other potential problems can be provided to the end user.

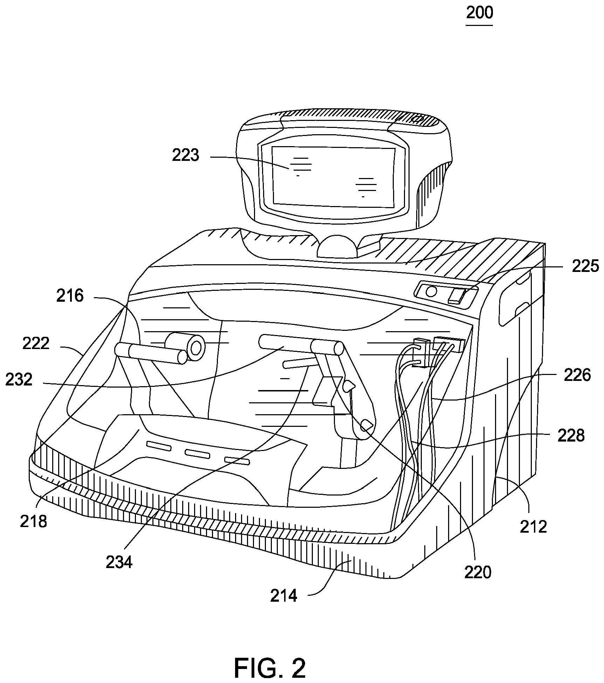

Turning now to FIG. 2, a perspective view of the alternator and starter motor tester 200 according to another exemplary embodiment of the present disclosure is illustrated. The alternator and starter motor tester 200 ("tester") has components similar to the tester 100 depicted in FIG. 1, however it has an alternative design. For example, tester 200 includes a housing 212 and a base plate (or chassis) 214. The housing 212 surrounds and supports various operative components of the tester 200 including, for example, a power supply, diagnostic electronics, mounting devices, a monitor screen 223, a protective door cover 222, and the like. In the embodiment depicted, the monitor screen 223, is an LCD touch-screen disposed within the housing 212. A power button 225, such as a toggle-switch design, is provided on the housing 212 to activate or deactivate test power to the driver motor (not shown) and/or the transformer (not shown). A main power switch (not shown) is also used to provide power to the tester 200.

The tester 200 also includes an alternator belt tensioning arrangement generally designated 216, an alternator mounting arrangement generally designated 218, and a starter motor holder arrangement generally designated as 220. Each of the belt tensioning arrangement 216, the alternator mounting arrangement 218, and the starter motor holder arrangement 220 may be mounted directly to the base plate 214 and include similar components described for FIG. 1 and thus are not repeated.

The test adapters 226 and power leads 228 may be connected to the alternator or starter motor in order to provide test information to tester 200. Additionally, a drive belt (not shown), such as a serpentine or V-type belt or the like, can be connected to the alternator and drive motor to simulate the operating environment in the vehicle. A gas piston may be used for belt tension to ensure consistent belt tension during testing and thereby eliminating over tensioning or slipping belts that may affect test results.

The starter motor holder arrangement 220 includes a quick release ratchet system, wherein the starter is placed on a pad and held in place by the ratchet system. The starter motor holder arrangement 220 includes, a handle 232 and a release lock 234 that when operated engages and disengages a lock (pawl, for example) from a ratchet (both not shown). The starter motor holder arrangement 220 helps to eliminate the use of straps, and alternatively uses the quick ratchet to hold the starter without the need of any additional holding mechanism or end user assistance during the test. Thus, the aforementioned arrangement makes the loading and unloading of components to be tested much more efficient. The starter motor may be placed in the tester 200 for testing. Upon the arrangement, the operator squeezes the release lock and presses down on the handle 232 to engage the starter motor and then releases the lock so that the lock is again reengaged. Power leads 228, including, for example, battery lead, ground lead, solenoid lead and sense lead are connected to the starter motor in order to conduct the tests.

In the embodiment depicted in FIG. 2, the tester 200 may incorporate enhanced safety features, such as the protective door cover 222 to enclose moving parts during tests. The protective door cover 222 conceals the belt tensioning arrangement 216, the alternator mounting arrangement 218, the starter motor holder arrangement 220, and other test components, such as an alternator or starter motor in the closed position. The protective door cover 222 of the tester 200 is shown covering at least the belt tensioning arrangement 216, the alternator mounting arrangement 218, and the starter motor holder arrangement 220 when in the closed position.

In the closed position, the protective door cover 222 reduces the likelihood of the possibility of hands getting caught in moving parts or projectiles potentially contacting the end user. The protective door cover 222 may employ a door interlock switch (not shown) to disable tests while the protective door cover 222 is open. Alternatively, the protective door cover 222 may include a viewing window so that the operator can observe the components during the tests.

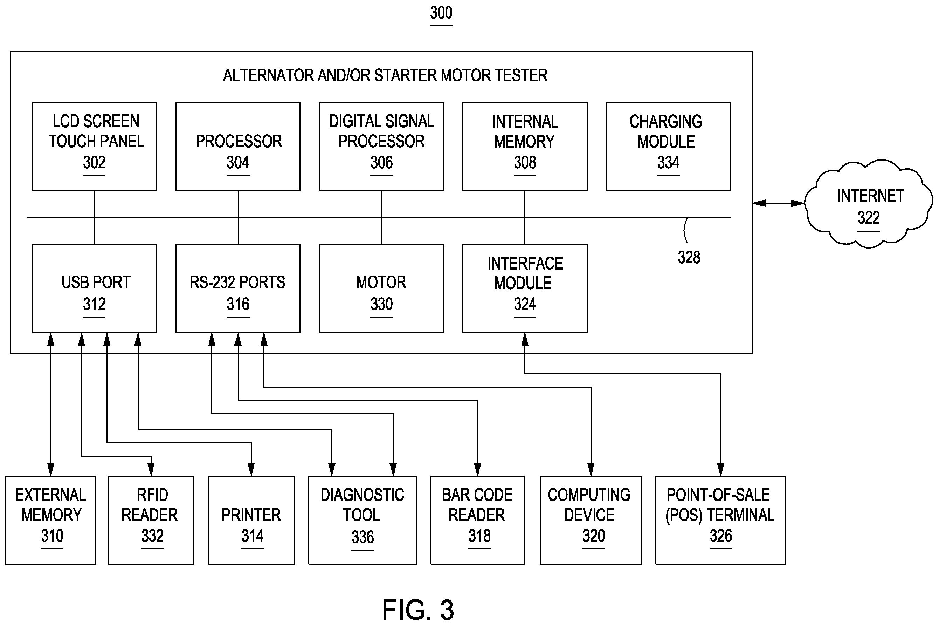

FIG. 3 is a block diagram 300 of the components of the alternator and starter motor tester as previously described and shown in FIGS. 1-2 according to an exemplary embodiment of the present invention. The components generally include a monitor screen, such as LCD screen 302 that may present various information to the user. The LCD screen 302 may be a touch panel to input information as desired by the user and can be controlled by a processor 304. The processor 304 may be any processor or controller, including a FPGA (Field Programmable Gate Array) or application-specific integrated circuit (ASIC). The processor 304 is capable of running various OS (Operating System) including Linux, Apple Computer's Operating System (such as OS X), Windows, Windows CE and the like. The processor 304 communicates with a digital signal processor 306, which includes an analog and digital (A/D) converter. The processor 304 communicates with other components (e.g., internal memory 308, USB port 312, RS-232 ports 316, motor 330, interface module 324 and/or charging module 334) of the tester 100 via a communication bus 328.

The processor 304 is configured to communicate with an internal memory 308 and an external memory 310. The internal memory 308 and/or the external memory 310 can be any memory including, for example, compact flash, SD (secure digital), USB flash drives, and the like. A universal serial bus (USB) port 312 communicates with the processor 304 and provides a connection for various USB compatible devices, such as, for example, the external memory 310, a printer 314, a radio frequency identification (RFID) reader 332 and/or a diagnostic tool 336. The RFID reader 332 functions to read identifying information about the tested component containing an RFID chip once it is within a detection range. The RFID chip may be integrated or separated from the tested component. The RFID chip may contain information about the alternator or starter motor such as alternator/starter motor type, serial number, manufacturer, date of production or shipment, previous test results, electrical specifications, diagnostic specification, maintenance information, bulletins, serial number, lot number, warranty information, a manufacture data code, method of shipment and the like.

RS-232 ports 316 also communicate with other external devices, such as a computing device 320, a bar code reader 318 and/or the diagnostic tool 336. The computing device 320 can be any computing device, including a personal computer, a laptop, a tablet, a personal digital assistant (PDA), a cell phone or the like. In another embodiment, the ports 312 and 316 may accommodate a data cable that may connect to a data link connector in a vehicle to retrieve diagnostic information, such as diagnostic trouble codes (DTCs).

Similarly, the diagnostic tool 336 can be any computing device and can provide additional diagnostic information to the tester 100. The additional diagnostic information may include diagnostic trouble codes (DTCs) that are set in a vehicle's electronic control unit. The DTCs can be used as tester as part of its analysis to determine if the issue is with the component under test or another component in the vehicle.

The bar code reader 318 allows the user to scan bar code information that may be attached to the tested component or the VIN (vehicle identification number) of the vehicle from which the tested component came from. The bar code reader 318 may be, for example, a conventional optical bar code reader, such as a gun or wand type reader. The bar code may provide a variety of information regarding the alternator or starter motor to be tested similar to information contained in an RFID.

During operation, the end user swipes or aims the bar code reader 318 over the bar code that is associated with the particular alternator or starter motor to be tested and reads the bar code accordingly. The bar code itself may be affixed to the alternator or starter motor at the time of manufacture, purchase, shipment or service. The bar code may contain information, or point to information stored in a database. The database may be local (e.g., internal memory 308) or remotely (e.g., external memory 310) located and accessible by the Internet, Ethernet, Wi-Fi, LAN, Bluetooth or other wireless or a wired connection. The data provided by the bar code is not limited to the examples given.

The interface module 324 may comprise a database (or access the internal memory 308 or the external memory 310 that stores the database) for storing information associated with the tested components and information associated with the diagnostic test performed by the tester 100. The information associated with the tested components may include, but not limited to, alternator/starter type, serial number, manufacturer, date of production or shipment, previous test results, electrical specifications, port connections, electrical configuration/layout, diagnostic specification, maintenance information, serial number, lot number, warranty information, a manufacture data code, method of shipment and the like. The information associated with the diagnostic test performed by the tester 100 may include, but not limited to, test specification, test values, test results (including previous test results), data, time, employee, location, weather condition during testing (extreme cold or heat that may affect the test) and/or any other information associated with the diagnostic test.

The bar code may provide a variety of information regarding the alternator or starter motor to be tested. For example, the bar code may provide information regarding the alternator/starter motor type, serial number, manufacturer, date of production or shipment, previous test results, electrical specifications, maintenance information, serial number, lot number, warranty information, a manufacture data code, method of shipment and the like. This data can be used to select parameters for the test cycle run to test the alternator and starter motor.

In some embodiments, the printer 314 may print bar code labels that may be attached or otherwise associated with the alternator or starter and provides updated information about the component. The updated information may include, among other things, service dates, service procedures (including the results), and warranty information (*e.g*., time left on warranty, who was the original purchaser, what types of service are and are not warranted, etc.). The printed label may then be read by the bar code reader 318 in subsequent tests. These features can eliminate possible typographical errors during manual input and by speeding up part number selection and entry by having a scanning capability.

The present disclosure also has the ability to store and display or print technical bulletins associated with specific part numbers of components to be tested. Printouts of test results can give rebuilders access to data obtained by users to assist in the further analysis of that component.

The interface module 324 may communicate with external devices coupled to the tester 100 100 as discussed herein for the (USB) port 312 and RS-232 ports 316. For example, the interface module 324 may communicate and receive identification information of the alternator or starter motor to be tested from the bar code reader 318, the RFID reader 332, and/or a POS terminal 326 through a direct or indirect connection. In an exemplary embodiment, the interface module 324 may communicate with the bar code reader 318 and receive bar code identification information of the alternator or starter motor to be tested. In another exemplary embodiment, the interface module 324 may communicate with the RFID reader 332 and receive RFID identification information of the alternator or starter motor to be tested. In other exemplary embodiment, the interface module 324 may communicate with the POS terminal 326 and receive identification information of the alternator or starter motor to be tested inputted by a user. The point-of-sale terminal 326 may be used to interact with the user or vehicle owner. At the point-of-sale terminal 326, the user may enter information such as parts number, cost of the component, credit card information, parts inventory, and the like.

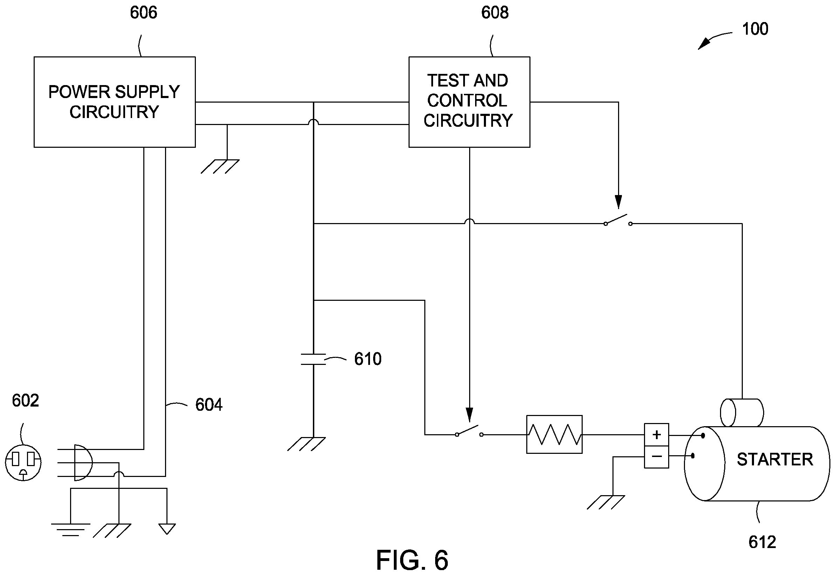

The interface module 324 may communicate with a charging module 334 that may control charging of a capacitive element (610 of FIG. 6) of the tester 100. For example, the interface module 324 may provide an electrical specification of the alternator or starter motor to be tested to the charging module 334 and the charging module 334 may charge the capacitive element based at least in part on the supplied electrical specification. The charging module 334 may charge a capacitive element of the tester 100 before testing of the alternator and/or starter motor. The charging module 334 may control an amount of power that is supplied to the capacitive element based at least in part on the alternator or starter motor to be tested. For example, an alternator or starter motor to be tested may require a smaller amount of power, the charging module 334 may supply the smaller amount of power to the capacitive element. While, an alternator or starter motor to be tested may require a larger amount of power, the charging module 334 may supply the larger amount of power to the capacitive element.

The charging module 334 may control a timing to charge the capacitive element of the tester 100. For example, the charging module 334 may supply a constant voltage potential and/or current to the capacitive element of the tester 100. The charging module 334 may start charging the capacitive element closer to the start of the test when an alternator or starter motor to be tested may require a smaller amount of power. While, the charging module 334 may start charging the capacitive element at an earlier time before the start of the test when an alternator or starter motor to be tested may require a larger amount of power. In another example, the charging module 334 may supply a variable voltage potential and/or current to the capacitive element of the tester 100. The charging module 334 may determine a charge time based at least in part on the variable voltage potential and/or current and the amount of charge required to test an alternator and/or a starter motor.

The charging module 334 may charge the capacitive element of the tester 100 continuously or intermittently. For example, the charging module 334 may continuously charge the capacitive element of the tester 100 in order to maintain the charged voltage potential of the capacitive element. In another exemplary embodiment, the charging module 334 may monitor a voltage potential stored in the capacitive element and may intermittently charge the capacitive element when the voltage potential stored in the voltage potential drops to a voltage charging threshold.

The charging module 334 may verify whether the capacitive element is properly charged based at least in part on the information of the alternator or starter motor to be tested. For example, the charging module 334 may detect the output voltage potential and/or current of the capacitive element and determine whether the detected output voltage potential and/or current matches an expected voltage potential and/or current stored in a data of either the internal memory 308 or the external memory 310.

The charging module 334 may also monitor an output voltage potential and/or current of the capacitive element of the tester 100 during the diagnostic test. The charging module 334 may determine when to couple a power source during the diagnostic test based at least in part on the output voltage potential and/or current of the capacitive element. For example, when the output voltage potential and/or current of the capacitive element is below a threshold output power level during a diagnostic test, the charging module 334 may determine to couple power to the tester 100 from the external power source (e.g., A/C or DC power source). In an exemplary embodiment, the charging module 334 may continue to supply power from the capacitive element in addition to the power supplied by the power source during the diagnostic test. In another exemplary embodiment, the charging module 334 may discontinue to supply power from the capacitive element once the power is supplied during the diagnostic test. The output threshold power level may be determined based at least in part on a power rating of the tester 100 and/or tested components.

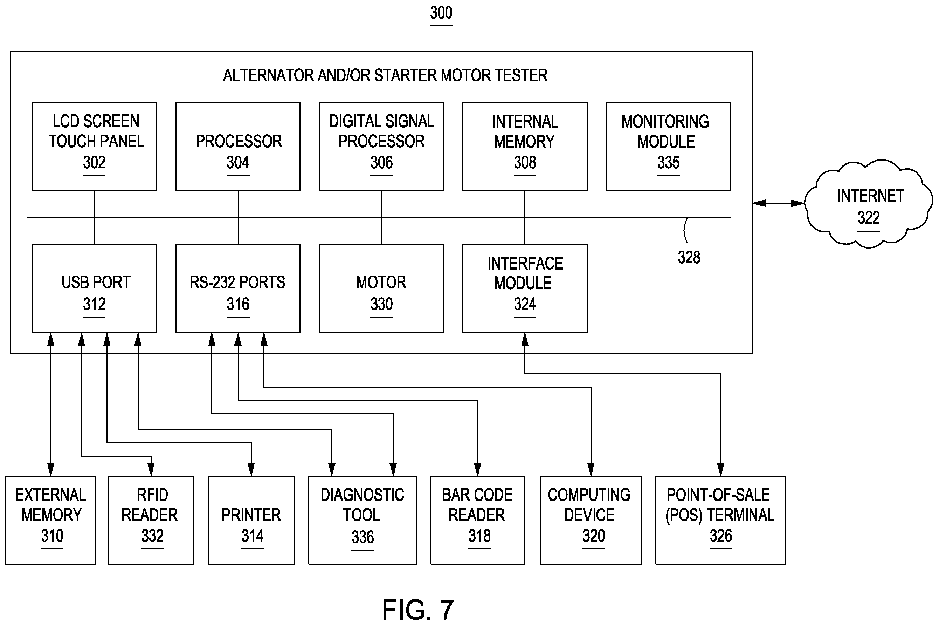

The interface module 324 may communicate with a monitoring module 335 (shown in FIG. 7) that may control an active load of the tester 100 to monitor and detect an input power level. For example, the interface module 324 may provide an electrical specification of the alternator or starter motor to be tested to the monitoring module 335 and the monitoring module 335 may monitor and control an input power level (e.g., input voltage potential and/or input current) based at least in part on the supplied electrical specification. In one embodiment, the monitoring module 335 may set a threshold voltage potential level and/or a threshold current level of the tester 100 before testing of the alternator and/or starter motor, and may control an amount of load that is applied to the alternator to be tested based at least in part on the threshold voltage potential level and threshold current level. If an alternator or starter motor to be tested can only supply a maximum load current of 15 amps or 25 amps, then the monitoring module 335 may monitor the input power level in order to control that the input power level does not exceed a predetermined threshold.

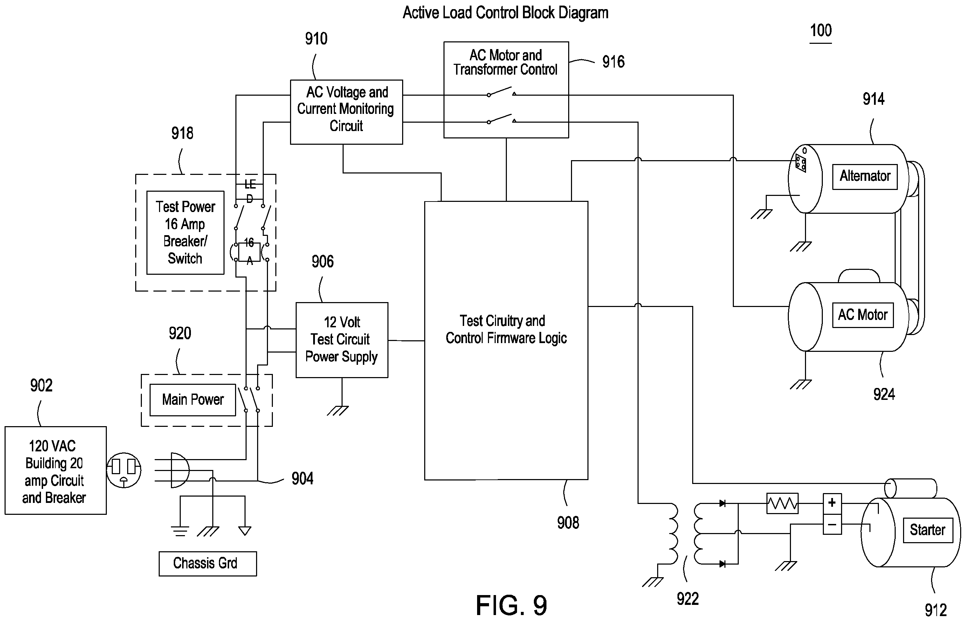

In order to control the input power, the monitoring module 335 may lower or cut off the load applied to the alternator if the input power level exceeds a threshold power level. In another embodiment, the monitoring module 335 may automatically disengage the tested component from the tester 100 or stop the testing cycle if the input power level exceeds a threshold power level. For example, the monitoring module 335 may automatically trip a breaker circuitry (shown in FIG. 9) when the input power level exceeds a predetermined threshold. In another example, the monitoring module 335 may provide an indication (e.g., visual or sound) to a user when the input power level exceeds a predetermined threshold and the user may manually cutoff the input power supply via a switch (shown in FIG. 9) or may manually disengage the tested component from the tester 100.

In one embodiment, the monitoring module 335 may continuously or intermittently monitor and detect an input power level of the tester 100. The monitoring module 335 may also verify whether the proper voltage potential and/or current is supplied to the tested component based at least in part on the information of the alternator or starter motor to be tested.

In another embodiment, during different stages of the test, different loads may be applied to the tested component and thus may require different input power levels to perform the test. The monitoring module 335 may monitor input power level at different stages of the test performed by the tester 100 and at any stage of the diagnostic test, the monitoring module 335 may terminate the test when the input power level exceeds a predetermined threshold. In another exemplary embodiment, the monitoring module 335 may monitor input power level at a first stage of the test to determine either to continue the test to a second stage or terminate the test based at least in part on the input power level during the first stage.

The monitoring module 335 may include galvanic isolated current monitoring circuit and voltage monitoring circuits. For example, galvanic isolated current and voltage monitoring circuits may include capacitive galvanic isolated circuit, inductive galvanic isolated circuit, electromagnetic galvanic isolated circuit, optical galvanic isolated circuit, acoustic galvanic isolated circuit, mechanical galvanic isolated circuit and other types of galvanic isolated circuits. The monitoring module 335 may be coupled to the input power circuitry of the tester 100 to monitor an input power of the tester 100. For example, the input power circuitry of the tester 100 and the monitoring module 335 may be coupled to different ground potentials and thus may enable the monitoring module 335 to prevent unwanted current to flow to the tested component.

The monitoring module 335 may communicate with external data sources (not shown) to transmit and receive information of various equipment (e.g., alternator or starter motor) to be tested. In an exemplary embodiment, the monitoring module 335 may receive updated electrical specification information of various equipment to be tested. The monitoring module 335 may be customized by a user of the tester 100. For example, the monitoring module 335 may create a list of equipment to be tested by a user. The information of the equipment to be tested may include, but not limited to, equipment type, serial number, manufacturer, date of production or shipment, electrical specifications, port connections, electrical configuration/layout, diagnostic specification, maintenance information, serial number, lot number, warranty information, a manufacture data code and the like.

The processor 304 can also interact with a networked computer, LAN (local area network), a smartphone, cellular phone or a distributed network, such as the Internet 322 and the like. This connection allows the user to update the tester 100 and also send information regarding the test results to a remote location. The information sent or received may include, software, firmware, language, weather reports and database for the components to be tested or to the tester 100, or results of the component that was tested.

A motor 330 is also provided in order to test alternators. Motor 330 can simulate the engine of a vehicle and includes a pulley to mate with a belt. At one end, the belt is coupled to the motor's 330 pulley and at the other end is coupled to the pulley of the alternator to be tested.

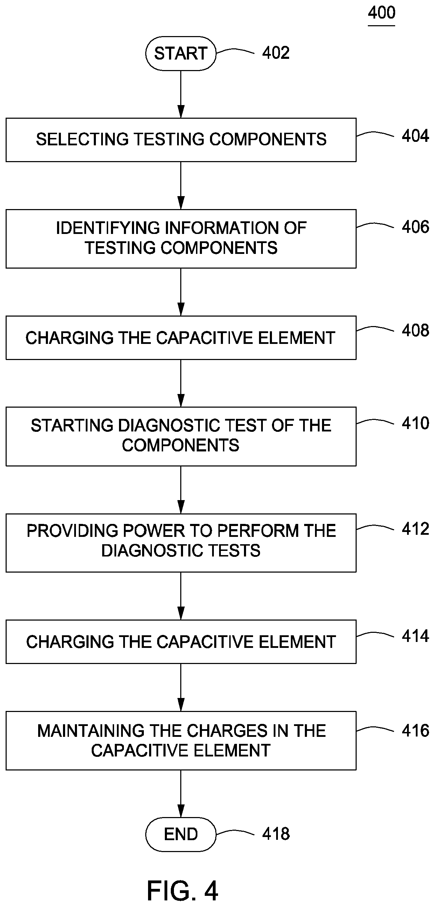

FIG. 4 illustrates a method 400 for conducting a diagnostic test by the alternator and starter motor tester 100 according to an embodiment of the present invention. This exemplary method 400 may be provided by way of example, as there are a variety of ways to carry out the method. The method 400 shown in FIG. 4 can be executed or otherwise performed by one or a combination of various systems, such as, the system and networks shown in FIGS. 1-3, 5 and 6, by way of example. Each block shown in FIG. 4 represents one or more processes, methods, or subroutines carried out in exemplary method 400 and the steps are not limited to the order shown in the figure. Referring to FIG. 4, exemplary method 400 may begin at step 402.

Starting at step 402, the user selects the component or the part to test at step 404 through an input device, such as the LCD screen 302 or the bar code or RFID chip. At step, 406, the interface module 324 identifies information associated with the tested components. For example, the interface module 324 may identify a power level (e.g., voltage potential and/or current) at which the tested component should be tested at. At step 408, the charging module 334 may start charging the capacitive element of the tester 100 based at least in part on the information associated with the tested components. In an exemplary embodiment, the charging module 334 may charge the capacitive element before a diagnostic test performed by the tester 100. In another exemplary embodiment, the charging module 334 may charge the capacitive element during a diagnostic test performed by the tester 100. The charging module 334 may charge the capacitive element for a period of time until the capacitive element reaches a power level to start the diagnostic test.

The capacitive element may be used to start the diagnostic test at step 410. The capacitive element may supply power to the tester 100 to start the diagnostic test of components to be tested. The charging module 334 may monitor an output voltage potential and/or current of the capacitive element. The charging module 334 may couple a power source to continue the diagnostic test of the components to be tested at step 412, when the output voltage potential and/or current falls to a testing threshold power level. After coupling the power source to perform the diagnostic test, the charging module 334 may decouple the capacitive element as a power source. In another example, the capacitive element may continue to provide power to the diagnostic test, after the charging module 334 couples the power source to perform the diagnostic tests. By coupling the power source with the capacitive element to supply a power to the tester 100, the tester 100 may test a component that may require higher power than the power source is able to supply. After the completion of the diagnostic test, the charging module 334 may charge the capacitive element for the next diagnostic test at step 414.

The charging module 334 may maintain the voltage potential stored in the capacitive element at step 416. For example, the charging module 334 may continuously supply a voltage potential and/or current to the capacitive element to replenish charges leaked in order to maintain a voltage potential stored in the capacitive element. In another example, the charging module 334 may intermittently supply a voltage potential and/or current to the capacitive element when the voltage potential stored in the capacitive element drops to a charging threshold power level due to leakage of charges to maintain a voltage potential stored in the capacitive element.

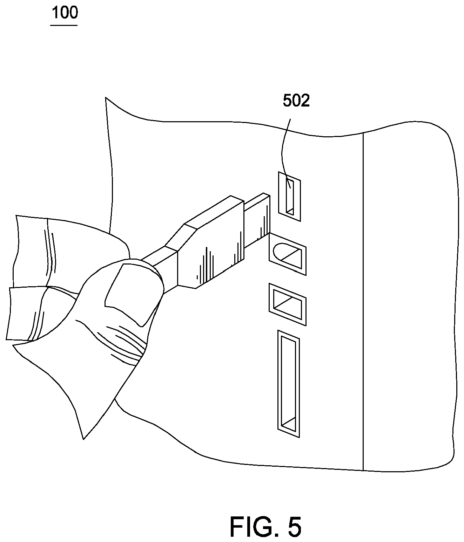

Referring to FIG. 5, in some embodiments of the alternator and starter motor tester, network connectivity may be used to track tests based on part number, employee and location in order to improve accuracy of the diagnostic test. The large-scale communication network ports can be constructed and arranged to receive an information relay device, such as an Ethernet wired module and/or an Ethernet wireless module. The Ethernet modules communicate at data rates of 10Mbps (10Base-T Ethernet), 100Mbps (Fast Ethernet), 1000Mbps (Gigabit Ethernet) and other data rates. The information relayed can include data from the result of an alternator or starter test, the part's warranty information, the part type, the part make and model, previous tests, updates, diagnostic or operating parameters of the alternator and starter tester, maintenance data of the alternator and starter tester, and any other data required by the operator.

Still referring to FIG. 5, in some embodiments, peripheral module ports 502 may be used to communicate to various peripheral devices such as a mouse, a keyboard, or a printer as well as to receive updates and/or downloads from a connected device such as a laptop or personal computer. The peripheral module ports 502 may be a USB module having ports for a host connection and a function connection. The USB module may communicate as USB 1.1 or USB 2.0, 3.0 or other data rates. The peripheral module ports 502 may also include a cable connection that may allow communication between the tester 100 and a vehicle. In some embodiments of the alternator and starter motor tester, network connectivity may be used to track tests based on part number, employee and location in order to improve accuracy of the diagnostic test.

FIG. 6 illustrates a circuit schematic diagram of an alternator and starter motor tester 100 according to an embodiment of the present disclosure. The tester 100 may be coupled to an external power source 602 (e.g., an alternating current (AC) power source) via an electrical connection 604. In an exemplary embodiment, the external power source 602 may be a 120V alternating current (AC) and 20A power source to power an operation of the tester 100. The tester 100 may also include a power supply circuitry 606. The power supply circuitry 606 may include a transformer circuitry and a rectifier circuitry (not shown) for converting the power received from the external power source 602 into a power that may be used by the tester 100. In an exemplary embodiment, the transformer circuitry of the power supply circuitry 606 may convert the 120V alternating current (AC) power signal to a 12V alternating current (AC) power signal. The rectifier circuitry (not shown) of the power supply circuitry 606 may convert (e.g., rectify) the 12V alternating current (AC) power signal to a 12V direct current (DC) power signal to power the tester 100.

For example, the power supply circuitry 606 may supply power to test and control circuitry 608 and a capacitive element 610 to run a starter motor 612 in order to perform a diagnostic test on an alternator or a starter motor. For example, the capacitive element 610 may be a high energy density (HED) capacitive element including, but not limited to, an ultracapacitor, a supercapacitor, electrochemical double layer capacitor (EDLC), a thin-film capacitor or any other high energy density (HED) capacitor. If ultracapacitors are implemented, the ultracapacitors may include a double-layer structure that polarizes an electrolytic solution to store energy electrostatically. However other types of ultracapacitor arrangements are contemplated as well. For example, the capacitive element 610 may be one or more ultracapacitors such as the ultracapacitors manufactured by Maxwell Technologies, San Diego, California, USA.

The capacitive element 610 may be configured to have sufficient capacitance as required to run the starter motor 612 for a period of time (e.g., several seconds) in order to test an alternator or a starter motor. For example, the capacitive element 610 may be a single capacitor element or a plurality of capacitor elements coupled to each other in parallel configuration to provide additional voltage and/or energy storage. Additionally or alternatively, the capacitor elements may be arranged in a series configuration to achieve a higher operating voltage potential. In an exemplary embodiment, the capacitive element 610 may be a capacitive module having a plurality of individual capacitors connected in series and parallel to each other via bus bar connections. In an exemplary embodiment, the capacitive element 610 may be configured to store sufficient charge (e.g., 12V) to run the starter motor 612 for a period of time. For example, the capacitive element 610 made be configured with six 100F 2.7 volt capacitors in series; and may be in parallel with another six 100F 2.7 volt capacitors in series. Of course, numerous other arrangements are contemplated as well.

The power supply circuitry 606 may supply power to the capacitive element 610 between tests of an alternator and/or a starter motor. The capacitive element 610 may discharge stored charges to run the starter motor 612 during testing. For example, an advantage of the capacitive element 610 is that the power supply circuitry 606 may have a lower current capacity than existing alternator and starter motor testers because the existing alternator and starter motor testers includes a transformer that requires higher current capacity (e.g., voltage and current for 5 seconds) to run the test. The capacitive element 610 may require lower current capacity because the capacitive element 610 may be charged for a longer period of time (e.g., at least a minute or two) between tests. In another example, the capacitive element 610 may eliminate the redundancy of two power supply circuitry 606 for separately supplying power to the test and control circuitry 608 and the starter motor 612. By using the capacitive element 610, the redundancy of the power supply circuitry 606 may be eliminated because the power supply circuitry 606 may supply power to both the test and control circuitry 608 and the capacitive element 610.

FIG. 7 is a block diagram 300 of the components of the alternator and starter motor tester according to another embodiment of the invention, As stated above, this diagram includes a monitoring module 335 as described herein.

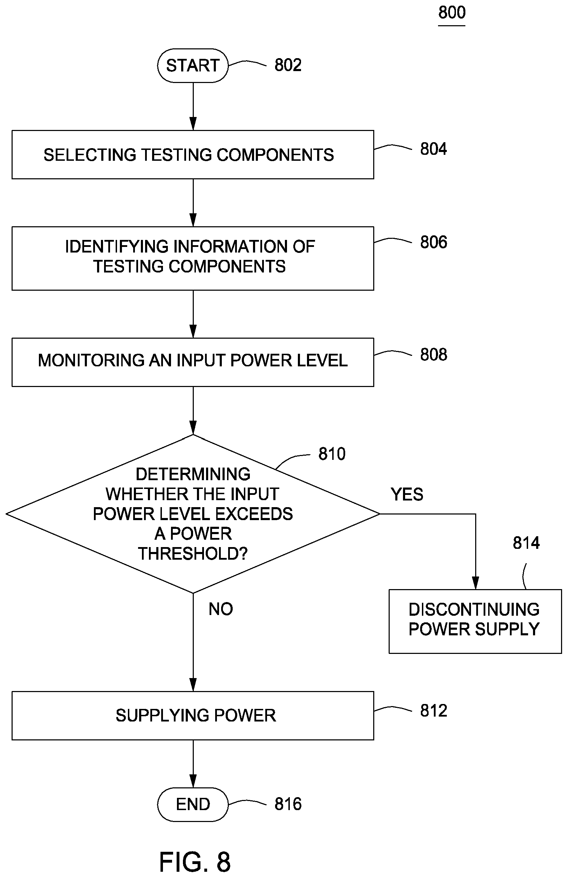

FIG. 8 illustrates a method 800 for conducting a diagnostic test according to an embodiment of the present disclosure. The method 800 starts at step 802 proceeds to step 804 where the user selects the component or the part to test through an input device, such as the LCD touch screen 302, the bar code or RFID chip. At step, 806, the interface module 324 identifies information associated with the tested components. For example, the interface module 324 may identify a power level (e.g., voltage potential and/or current) at which the tested component should be tested as based on information in the database or from the barcode or RFID chip. At step 808, the monitoring module 335 may monitor an input power level (e.g., input voltage potential and/or input current) of the tester 100. The monitoring module 335 may determine whether to terminate the test based at least in part on the information associated with the tested components at step 810. In exemplary embodiments, the monitoring module 335 may determine whether the input power level is above a power level required to test the component or whether the input power level is above a predetermined threshold. In addition, the monitoring module 335 may determine whether to continue testing the component at a second stage based at least in part on an input power level during a first stage.

Based on the determination, the monitoring module 335 may continue to couple the power supply to continue the diagnostic test of the components to be tested at step 812, when the input power level does not exceed a threshold power level. Alternatively, the monitoring module 335 may decouple the power supply and discontinue the diagnostic test of the components to be tested at step 814 when the input power level exceeds a threshold power level. It may be appreciated by one of skilled in the art that the monitoring module 335 may continuously or intermittently monitor the input power level to determine whether the input power level exceeds a predetermined power threshold.

As described above, the capacitive elements may provide an additional source of power that may allow for the use of smaller and less costly circuit components in the starter motor tester; the smaller and less costly circuit components may have reduced power consumption; and the capacitive elements may be sufficiently charged by the smaller circuit components when the starter motor tester is not being utilized.

FIG. 9 illustrates a circuit schematic diagram of an alternator and starter motor tester 100 according to an embodiment of the present disclosure. The tester 100 may be coupled to an external power source 902 (e.g., an alternating current (AC) power source) via an electrical connection 904. In an exemplary embodiment, the external power source 902 may be a 120V alternating current (AC) and 20A power source to power an operation of the tester 100. The tester 100 may also include a power switch 920 and a power supply circuitry 906. The power switch 920 may be switched by a user to turn the tester 100 "ON" and "OFF" to perform a diagnostic test of vehicular components. The power supply circuitry 906 may include a transformer circuitry and a rectifier circuitry (not shown) for converting the power received from the external power source 902 into a power that may be used by the tester 100. In an exemplary embodiment, the transformer circuitry of the power supply circuitry 906 may convert the 120V alternating current (AC) power signal to a 12V alternating current (AC) power signal. The rectifier circuitry (not shown) of the power supply circuitry 906 may convert (e.g., rectify) the 12V alternating current (AC) power signal to a 12V direct current (DC) power signal to power the tester 100.

For example, the power supply circuitry 906 may supply power to a test and control circuitry 908 to run a transformer 922 and an alternating current (AC) motor 924 via a drive control circuitry 916. The test and control circuitry 908 may provide one or more control signals to the drive control circuitry 916 to control the a power level supplied to the transformer 922 and the AC motor 924 to perform diagnostic test on the starter motor 912 and the alternator 914, respectively. During the diagnostic test, the monitoring circuitry 910 may monitor an input power level (e.g., input voltage potential and/or input current) to the tester 100. In the event that the input power level exceeds a predetermined threshold, the monitoring circuitry 910 may cutoff the power supply to the AC motor 924 or the transformer 922 via the drive control circuitry 916 to stop the diagnostic test. The breaker/switch circuitry 918 may include a switch that may allow a user to manually turn the switch ON and OFF to cutoff the power supply to stop the diagnostic test. Also, the breaker/switch circuitry 918 may include a breaker that may be tripped when the monitoring circuitry 910 does not detect that the power level exceeds a predetermined threshold.

For example, the monitoring circuitry 910 may monitor the power level (e.g., voltage potential and/or current) at different stages of the diagnostic test. The monitoring circuitry 910 may monitor the power level at different stages of the diagnostic test performed by the tester 100. During any stage of the test, the monitoring circuitry 910 may terminate the test when the input power level exceeds a predetermined threshold by turning off the drive control circuitry 916. In another exemplary embodiment, the monitoring circuitry 910 may monitor a power level at a first stage of the diagnostic test to determine either to continue the diagnostic test to a second stage or terminate the diagnostic test by turning off the drive control circuitry 916. In another exemplary embodiment, the monitoring circuitry 910 may cutoff the power supply during any stage of the diagnostic test when the power level exceeds a predetermined threshold.

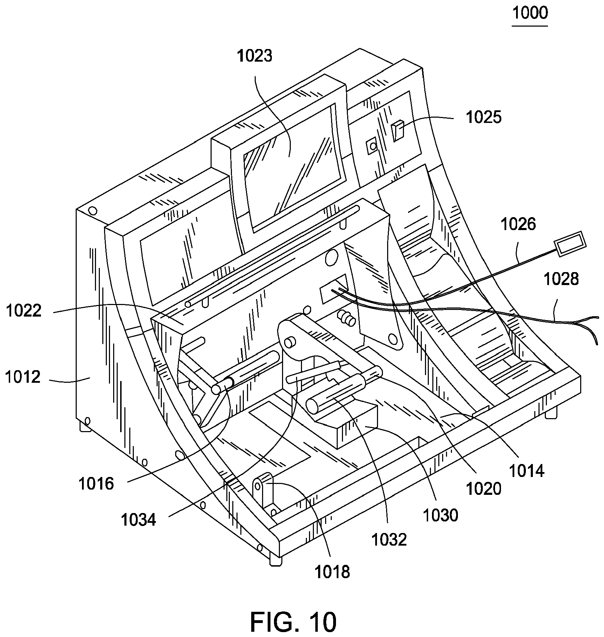

Another aspect of the present testing apparatus is illustrated in Figure 10. Figure 10 illustrates an alternator and starter motor tester 1000 ("tester") including a housing 1012 and a base plate (or chassis) 1014. The housing 1012 surrounds and supports various operative components of the tester 1000 including, for example, a power supply, diagnostic electronics, mounting devices, a monitor screen 1023, a protective door cover 1022, and the like. In one aspect, the monitor screen 1023, e.g., LCD (LIQUID-CRYSTAL DISPLAY) touch-screen may be disposed within the housing 1012. A test power button 1025, such as a toggle-switch, is provided on the housing 1012 to activate and de-activate test power to the drive motor (not shown) and/or a transformer (not shown). A main power switch (not shown) may also be used to provide power to the tester 1000.

The tester 1000 also includes an alternator belt tensioning arrangement generally designated 1016, an alternator mounting arrangement generally designated 1018. The tester 1000 may also include the ability to test a starter and may include a starter motor holder arrangement generally designated as 1020. The belt tensioning arrangement 1016 and the alternator mounting arrangement 118 may be mounted directly to the base plate 1014.

The alternator belt tensioning arrangement 1016 and the alternator mounting arrangement 1018 together hold the alternator in place for testing. An installation assembly that includes one or more mounting pins (not shown) can be placed in the alternator mounting arrangement 1018 in order to mount the alternator. The alternator can be horizontally or vertically mounted depending on the type of alternator. The pins are replaceable to allow flexibility for current and future applications.

Also shown in Figure 10, a test adapter 1026 and power leads 1028 can be connected to the alternator in order to provide test information to the tester 1000. Additionally, a drive belt (not shown), such as a serpentine or V belt or the like, can be connected to the alternator and the drive motor to simulate the operating environment in the vehicle. A gas piston may be used for belt tensioning to ensure consistent belt tension during testing, thereby eliminating over tensioning or belt slippage that may affect test results.

The starter motor holder arrangement 1020 includes a quick release ratchet system, wherein the starter is placed on a pad and held in place by the ratchet system. The starter motor holder arrangement 1020 includes, a support pad 1030, a handle 1032 and a release lock 1034 that when operated engages and disengages a lock (pawl, for example) from a ratchet (both not shown). The starter motor holder arrangement 1020 helps to eliminate the use of straps, and alternatively uses the quick ratchet to hold the starter without the need of any additional holding mechanism or end user assistance during the test. Thus, the aforementioned arrangement makes the loading and unloading of components to be tested much more efficient. The starter motor may be placed on the support pad 1030 for testing. Upon the placement, the operator squeezes the release lock and presses down on the handle 1032 to engage the starter motor and then releases the lock so that the lock is again reengaged. The starter motor may be powered by a transformer (not shown) in order to simulate operating environments. The transformer may be powered by an external power source and may provide test power to the starter motor via a heavy duty cable and clamps. Power leads 1028, including, for example, battery lead, ground lead, solenoid lead and sense lead are connected to the starter motor in order to conduct the tests.

Figure 10 also illustrates the monitor screen 1023 that can operate as a touch-screen LCD user interface that communicates with a controller (discussed herein) as well as to display information to the end user. The present disclosure also utilizes an on-line tutorial for quickly training new personnel on the unit's functionality and on-line help screens to help new users navigate and test components during a test. The monitor screen 1023 may offer step-by-step instructions for setting up the tester 1000 and conducting tests. The monitor screen 1023 may also display on-screen hook up diagrams and a specification library database, which may eliminate the need for paper flipcharts and enables software updates for new alternator applications or starter configurations. This database can be updated by compact flash, flash drive, and other memory media or remotely via a network connection (discussed below). The monitor screen 1023 may allow end users to run advertising screens when the tester is not in use. These screens can be uploaded to the tester 1000 from an end user's network server or uploaded from a compact flash or other memory media. Additionally, the monitor screen 1023 may be capable of displaying information in various updatable languages.

The tester 1000 may output "Good/Bad" or "Pass/Fail" results to the end user. An end user printout that details test results and provides technical advice for other potential problems can be provided to the end user.

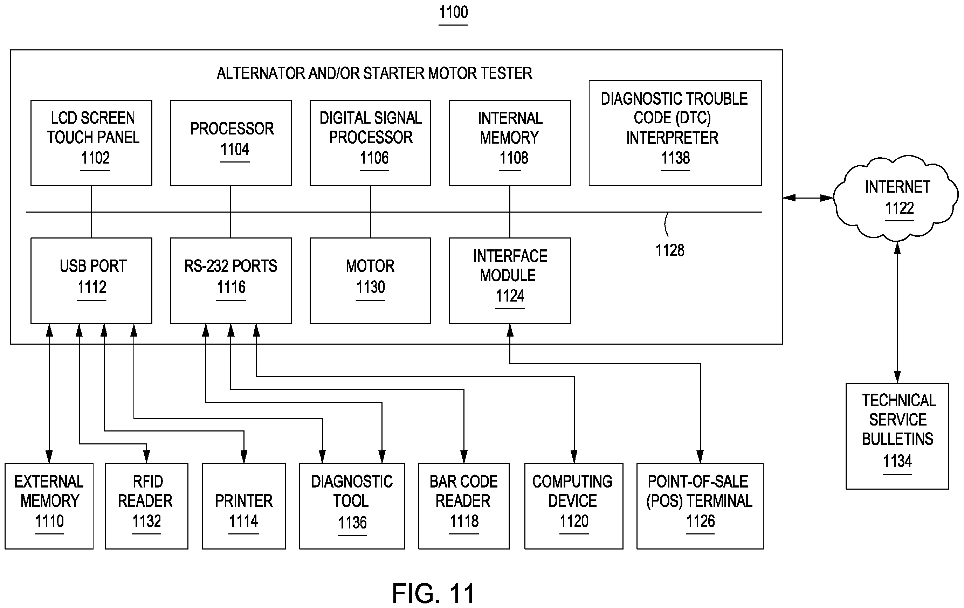

Figure 11 is a block diagram 1100 of the components of the alternator and starter motor tester as previously described and shown according to another exemplary aspect of the invention. The components generally include a monitor screen, such as LCD screen 1102 that provides various information to the user. The LCD screen 1102 may be a touch panel to input information as desired by the user and can be controlled by a processor 1104. The processor 1104 may be any processor or controller, including a FPGA (Field Programmable Gate Array). The processor 1104 is capable running various OS (Operating System) including Linux, Apple Computer's Operating System (such as OS X), Windows, Windows CE and the like. The processor 1104 communicates with a digital signal processor 1106, which includes an analog and digital (A/D) converter. The processor 1104 communicates with other components (e.g., internal memory 1108, USB port 1112, RS-232 ports 1116, motor 1130, interface module 1124 and/or diagnostic trouble code (DTC) interpreter 1138) of the tester 1100 via a communication bus 1128.

The processor 1104 is configured to communicate with an internal memory 308 and an external memory 1110. The internal memory 308 and/or the external memory 1110 can be any memory including, for example, compact flash, SD (secure digital), USB flash drives, and the like. A universal serial bus (USB) port 1112 communicates with the processor 1104 and provides a connection for various USB compatible devices, such as, for example, an external memory 1110, a printer 1114, a radio frequency identification (RFID) reader 1132 and/or a diagnostic tool 1136. The RFID reader 1132 functions to read identifying information about the tested component containing an RFID chip once it is within a detection range. The RFID chip may contain information about the alternator or starter motor such as alternator/starter motor type, serial number, manufacturer, date of production or shipment, previous test results, electrical specifications, maintenance information, serial number, lot number, warranty information, a manufacture data code, method of shipment and the like.

The processor 1104 also communicates with an interface module 1124. The interface module 1124 communicates with other external devices or external websites, such as a technical service bulletins (TSB) 1134 through Internet 1122. The interface module 1124 includes a database (or access the internal memory 1108 or the external memory 1110 that stores the database) for storing information associated with the tested components and information associated with the diagnostic test performed by the tester 1100. The RS-232 ports 1116 also communicate with other external devices, such as a computing device 1120, a bar code reader 1118 and/or the diagnostic tool 1136. In another exemplary aspect, the interface module 1124 communicates with the technical service bulletins (TSB) 1134 via the point-of-sale (POS) terminal 1126. Further details of these components are described in United States patent application serial number 13/463,292 filed May 3, 2012 and incorporated by reference herein in its entirety.

As described above, Alternator testers typically use a 120 VAC Motor to provide rotational drive to the alternator by means of a belt. Other configurations are contemplated as well. The drive capability of the motor to the alternator is largely dependent on the tension of the belt to prevent slippage under load. Without adequate belt tension, the belt can slip at either the driving pulley, on the motor, or at the driven pulley on the alternator, or both.

The alternator is designed to generate the proper DC voltage (typically 13.8 to 14.5 VDC) when driven over a range of RPM (revolutions per minute), typically about 800 to 10,000 RPM. If the alternator RPM slows to less than the low design RPM, the alternator's ability to generate the design voltage may not maintained. When the belt between the motor pulley and the alternator pulley is not fully tightened by the operator adequately, the belt can slip on one or both of the pulleys and the alternator RPM may drop below the design RPM, which will result in the Alternator output voltage being below the design voltage i.e.,13.8 v. Having this occur during the testing of the Alternator output would result in a failure decision of the Alternator Test. This "False" failure can cause the Alternator to be returned for warranty, thus incorrectly causing the cost of replacing the alternator. Additionally, it may cause the technician to incorrectly determine the cause of the problem in the power system. Therefore a "False" failure due to belt slip is highly undesirable.

The alternator is typically designed with inductive coils that create an alternating current (AC) voltage, which is rectified using diodes with each coil to produce a direct current (DC) voltage for charging the battery in a vehicle. The rectification by the diodes is not complete in that there is some level of ripple in the voltage after the rectification. The ripple frequency is generally directly proportional to the RPM of the alternator, the number of coils and/or diodes used in the specific design of the alternator.

This invention uses this ripple frequency proportional to the alternator RPM to determine if belt slip may be occurring. Belt slip when testing an alternator with the belt is not tightened sufficiently typically occurs when an electrical load is connected to the alternator output. This electrical load requires the alternator to produce more current in order to maintain the design output voltage. Producing more current requires more input power to the alternator pulley through the belt. The increase in power demand can cause belt slip.

When determining whether belt slip is occurring, the absolute (specific amount of RPM such as 655 rpm) RPM is not needed, because the RPM before the load is connected compared to the RPM after the load is connected can be analyzed for change. Specifically, if the RPM after the load is connected is significantly lower than the RPM before the load is connected, the reduced RPM is likely due to belt slip.

This invention measures the frequency of the voltage ripple on the output of the alternator, and converts it to a voltage related to the alternator RPM. Recording the frequency while the alternator is running (being driven by the motor through the belt) but without any electrical load as F(nl) (Frequency with no-load) and recording the frequency shortly after the electrical load is connected to the alternator as F(l1) (Frequency with load-one). The determination of whether the belt is slipping or not is determined by calculating the difference of the two frequencies; (Fnl - Fl1) = F(dif). Determining whether the frequency difference is larger than the expected amount that the motor may slow down due to the electrical load only, this can be described as X% of F(nl). If the frequency F(dif) is greater than frequency with no-load F(nl), times the percent of expected frequency slow down, it is highly likely there is belt slip occurring. With this condition the test can be stopped and the operator instructed to tighten the belt before starting the test again. This would prevent the cost of an alternator replacement under warranty on a "False" failure.

In other aspects, the belt slip check may be determined after a second heavier electrical load is connected. In this regard, it may be desirable to load the alternator with two separate loads. Having two separate loads allows a lighter load to be applied if the AC line voltage is low, and may be too low for the alternator tester to operate or trip a circuit breaker if the heavier load were applied. The belt slip procedure may be applied to analyze the RPM before and after the second load is connected, in the event that the belt slips only when the heavier load is applied.

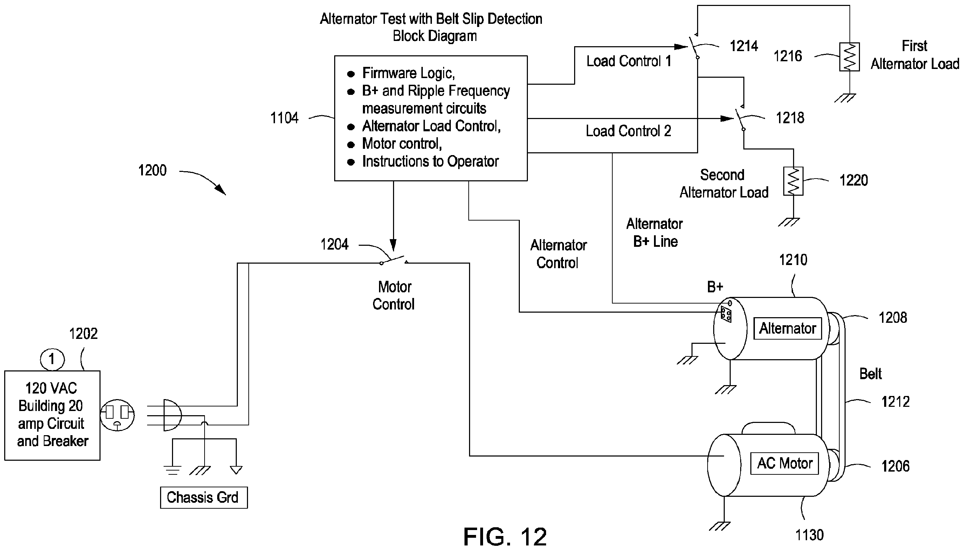

Figure 12 is a block diagram of the alternator test system with belt slip detection in accordance with an aspect of the invention. In particular, Figure 12 shows a block diagram 1200 of the alternator tester. The alternator 1210 may be positioned in the alternator tester and connected with a belt 1212 to the motor 1130. The belt 1212 may be connected to a pulley 1208 of the alternator 1210 and a pulley 1206 of the motor 1130.

The motor 1130 may be driven by a 120 V alternating current power source 1202. Other power sources are contemplated as well. The power source may be directly connected to the AC motor 1130 or through a motor control 1204. The motor control 1204 may connect and disconnect the power from the power source 1202 to the motor 1130. More particularly, the motor control 1204 may be a solenoid switch that is controlled by the processor 1104. Other types of switches are contemplated as well.

After power from the power source 1202 is provided to the AC motor 1130 through a closed switch of the motor control 1204, the motor 1130 rotates and subsequently rotates the alternator 1210. Rotating the alternator 1210 will provide a power output from the B+ output of the alternator 1210.

During this rotation of the alternator 1210, the processor 1104 or similar components may measure the ripple frequency of the power generated by the alternator 1210 at described below in more detail. The alternator tester may further include an alternator load that may include a switch 1214 that may be controlled by the processor 1104 and a resistive load 1216 that is grounded. This alternator load may cause the belt 1212 to slip as described herein.

The alternator tester may further include a second load that includes a switch 1218 that may be controlled by the processor 1104 and a resistive load 1220 that is grounded. This second alternator load may further cause the belt 1212 to slip as described herein.

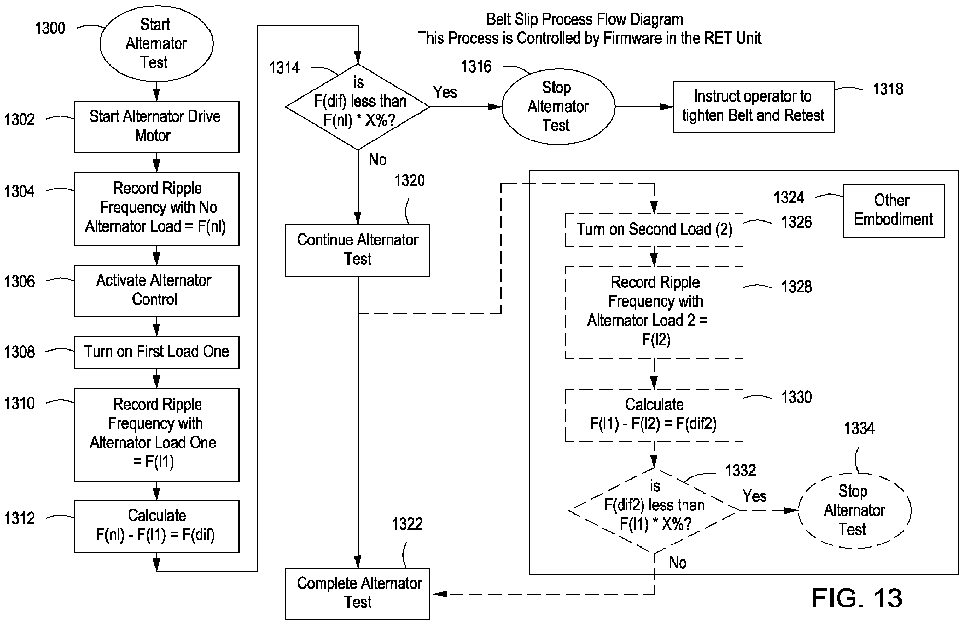

Figure 13 is a process flow diagram of the belt slip system in accordance with an aspect of the invention. In particular, Figure 5 shows an alternator test process 1300. At 1302 the alternator drive motor may be started by the application of power. Thereafter, the ripple frequency with no alternator load may be recorded at 1304. Subsequently, at 1306 the alternator control may be activated. Next, at step 1308 a first load may be turned on, as described above, to provide a load to the alternator 1210. Once this first load is applied to the alternator 1210, the ripple frequency of the alternator is recorded at 1310. Subsequently, the difference between the ripple frequency recorded at 1304 and the ripple frequency recorded at 1310 is determined at 1312.

In 1314, the difference between the two frequencies is determined, and is further determined whether or not it exceeds a particular percentage (X%) at 1314. If it is determined in step 1314 that the difference exceeds a particular percentage (yes), then the alternator test will be stopped at 1316 and the technician instructed to tighten the belt and retest at 1318.

On the other hand, if the difference does not exceed a particular percentage (no), the alternator test will continue at 1320 and be completed at 1322.

Additionally, the alternator test process 1300 may further include a second load process 1324. In this regard, after 1320, the second load may be turned on at 1326, the ripple frequency recorded at 1328, and another difference calculation conducted at 1330. In 1332 the difference between the ripple frequency determined at 1310 and the ripple frequency determined at 1328 may be compared to determine whether or not the difference exceeds a particular percentage (X%). If the difference exceeds the percentage (yes), then the alternator test may be stopped at 1334. Additionally, the technician may be instructed to tighten the belt and retest. On the other hand, if the difference does not exceed the predetermined percentage (no), the alternator test may be completed at 1322.

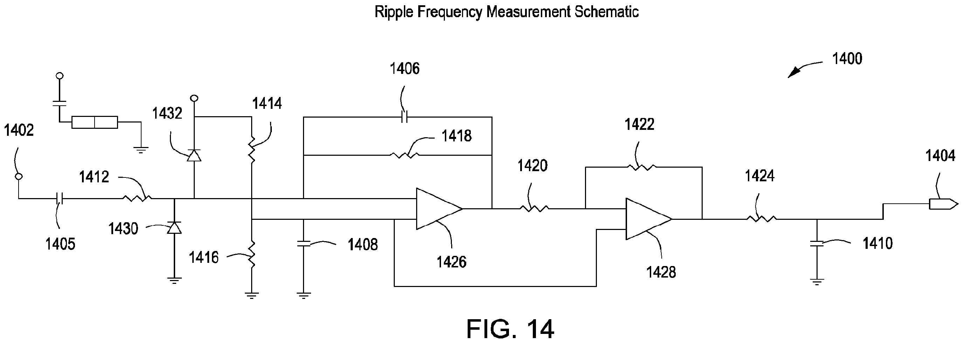

Figure 14 is a schematic of the ripple frequency measurement device in accordance with an aspect of the invention. In particular, Figure 14 shows a circuit 1400 that measures ripple frequency. The input of circuit 1400 is at 1402 that may be connected to the B+ output from the alternator. The output of circuit 1400 is at 1404 and includes an analog-to-digital converter. The analog to digital converter 1404 generating a digital output of the ripple signal. The circuit 1400 further includes capacitors 1405, 1406, 1408, and 1410; resistors 1412, 1414, 1416, 1418, 1420, 1422, and 1424; op amps 1426 and 1428; and diodes 1430 and 1432 arranged as shown in Figure 14. In operation, the input 1402 receives the ripple voltage output from the alternator and counts the ripples that are generated as described above to provide a digital output at the analog-to-digital converter 1404.

In further aspects, the frequency may be checked after motor is started to ensure alternator is running at a predetermined minimum RPM. In yet another aspect of the invention, the invention could be used to check for belt slip when the alternator is first started. Shortly after the motor is started to drive the alternator at a desired RPM, the alternator RPM may be checked to ensure that it has reached a minimum RPM. The minimum RPM would be predetermined and specified for each alternator. In this regard, a RPM specific to each alternator is required because for a motor with a specific design RPM and a motor pulley with a specific diameter, the alternator RPM may still be different due to the diameter size pulley it is designed with. In addition the frequency of the ripple is dependent on the number of coils and diodes in the specific alternator design, and is not the same for all alternators. So the alternator pulley diameter and the number of coils and diodes would need to be known for a minimum RPM. These parameters can be recorded with the part number for a specific alternator, and used to set variables in the Belt Slip algorithm to calculate the minimum RPM.

In further aspects, the frequency may be checked after motor is started to ensure alternator is running at a predetermined minimum RPM. In yet another aspect of the invention, the invention could be used to check for belt slip when the alternator is first started. Shortly after the motor is started to drive the alternator at a desired RPM, the alternator RPM may be checked to ensure that it has reached a minimum RPM. The minimum RPM would be predetermined and specified for each alternator. In this regard, a RPM specific to each alternator is required because for a motor with a specific design RPM and a motor pulley with a specific diameter, the alternator RPM may still be different due to the diameter size pulley it is designed with. In addition the frequency of the ripple is dependent on the number of coils and diodes in the specific alternator design, and is not the same for all alternators. So the alternator pulley diameter and the number of coils and diodes would need to be known for a minimum RPM. These parameters can be recorded with the part number for a specific alternator, and used to set variables in the Belt Slip algorithm to calculate the minimum RPM.

Accordingly, the invention as described herein determines whether the test equipment is properly operating before and/or during testing of the alternator so that the alternator function may be properly determined.

The invention may be implemented in any type of computing devices, such as, e.g., a desktop computer, personal computer, a laptop/mobile computer, a personal data assistant (PDA), a mobile phone, a tablet computer, cloud computing device, and the like, with wired/wireless communications capabilities via the communication channels.

Further in accordance with various embodiments of the invention, the methods described herein are intended for operation with dedicated hardware implementations including, but not limited to, PCs, PDAs, semiconductors, application specific integrated circuits (ASIC), programmable logic arrays, cloud computing devices, and other hardware devices constructed to implement the methods described herein.

It should also be noted that the software implementations of the invention as described herein are optionally stored on a tangible storage medium, such as: a magnetic medium such as a disk or tape; a magneto-optical or optical medium such as a disk; or a solid state medium such as a memory card or other package that houses one or more read-only (non-volatile) memories, random access memories, or other re-writable (volatile) memories. A digital file attachment to email or other self-contained information archive or set of archives is considered a distribution medium equivalent to a tangible storage medium. Accordingly, the invention is considered to include a tangible storage medium or distribution medium, as listed herein and including art-recognized equivalents and successor media, in which the software implementations herein are stored.

## Claims

1. A diagnostic tool (336, 1136) configured to test a performance of a vehicle component, the diagnostic tool (336, 1136) comprising:
a processor (304, 1104) configured to process test information from the vehicle component and control the vehicle component to be tested;
a memory (308, 1110) configured to store the test information of the vehicle component and software that operates the vehicle component;
a capacitive element (610) configured to supply power to perform the testing of the vehicle component,
wherein the memory (308, 1110) and the capacitive element (610) are in communication with the processor (304, 1104),
**characterized by**
a charging module (334) that controls a timing and an amount of charge provided to the capacitive element (610),
wherein the charging module (334) charges the capacitive element (610) based at least in part on an amount of power required to perform the testing of the vehicle component.

2. The diagnostic tool (336, 1136) of claim 1, wherein the vehicle component is a starter motor component and the processor (304, 1104) is also configured to control the starter motor and process starter motor information.

3. The diagnostic tool (336, 1136) of claim 1, wherein the vehicle component is an alternator (914, 1210) and the processor (304, 1104) is also configured to control the alternator (914, 1210) and process alternator information.

4. The diagnostic tool (336, 1136) of claim 1, wherein the charging module (334) charges the capacitive element (610) with a constant voltage potential and/or current.

5. The diagnostic tool (336, 1136) of claim 1, wherein the charging module (334) charges the capacitive element (610) with a variable voltage potential and/or current.

6. The diagnostic tool (336, 1136) of claim 1, further comprising an interface module (324, 1124) configured to receive identification information of a component of the vehicle to be tested.

7. The diagnostic tool (336, 1136) of claim 6, wherein the interface module (324, 1124) is configured to receive the identification information from a barcode reader, a RFID reader or a point-of-sale (POS).

8. The diagnostic tool (336, 1136) of claim 1, wherein the test information includes at least one of the following: test specification, test values, test results, data, time, employee, location and weather condition.

9. The diagnostic tool (336, 1136) of claim 1, wherein the capacitive element (610) comprises a plurality of capacitive elements.

10. A method of testing a vehicle component, comprising the steps of:
receiving, via an input device, a selection of the vehicle component for testing;
identifying, via an interface module (324, 1124), information associated with the vehicle component;
charging, via a charging module (334), a capacitive element (610) based at least in part on information associated with the vehicle component in order to perform the testing of the vehicle component, **characterized by**
controlling, via the charging module (334), a timing and an amount of charge provided to the capacitive element (610),
wherein the charging module (334) charges the capacitive element (610) based at least in part on an amount of power required to perform the testing of the vehicle component.

11. The method of claim 10, wherein identifying information associated with the vehicle component comprises identifying a power level at which the vehicle component should be tested at.

12. The method of claim 10, wherein charging the capacitive element (610) comprises charging the capacitive element (610) before performing the testing of the vehicle component.

13. The method of claim 10, wherein charging the capacitive element (610) comprises charging the capacitive element (610) during the testing of the vehicle component.

## Patentansprüche

1. Diagnosewerkzeug (336, 1136), das dazu konfiguriert ist, eine Leistung einer Fahrzeugkomponente zu testen, wobei das Diagnosewerkzeug (336, 1136) Folgendes umfasst:
einen Prozessor (304, 1104), der dazu konfiguriert ist, Testinformationen von der Fahrzeugkomponente zu verarbeiten und die zu testende Fahrzeugkomponente zu steuern;
einen Speicher (308, 1110), der dazu konfiguriert ist, die Testinformationen der Fahrzeugkomponente und Software, die die Fahrzeugkomponente betreibt, zu speichern;
ein kapazitives Element (610), das dazu konfiguriert ist, Leistung zum Ausführen des Tests der Fahrzeugkomponente zuzuführen,
wobei der Speicher (308, 1110) und das kapazitive Element (610) mit dem Prozessor (304, 1104) in Verbindung stehen,
**gekennzeichnet durch**
ein Lademodul (334), das einen Zeitpunkt und eine dem kapazitiven Element (610) bereitgestellte Ladungsmenge steuert,
wobei das Lademodul (334) das kapazitive Element (610) zumindest teilweise auf der Grundlage einer zum Ausführen des Tests der Fahrzeugkomponente erforderlichen Leistungsmenge lädt.

2. Diagnosewerkzeug (336, 1136) nach Anspruch 1, wobei die Fahrzeugkomponente eine Anlasserkomponente ist und der Prozessor (304, 1104) außerdem dazu konfiguriert ist, den Anlasser zu steuern und Anlasserinformationen zu verarbeiten.

3. Diagnosewerkzeug (336, 1136) nach Anspruch 1, wobei die Fahrzeugkomponente eine Lichtmaschine (914, 1210) ist und der Prozessor (304, 1104) außerdem dazu konfiguriert ist, die Lichtmaschine (914, 1210) zu steuern und Lichtmaschineninformationen zu verarbeiten.

4. Diagnosewerkzeug (336, 1136) nach Anspruch 1, wobei das Lademodul (334) das kapazitive Element (610) mit einem konstanten Spannungspotential und/oder Strom lädt.

5. Diagnosewerkzeug (336, 1136) nach Anspruch 1, wobei das Lademodul (334) das kapazitive Element (610) mit einem variablen Spannungspotential und/oder Strom lädt.

6. Diagnosewerkzeug (336, 1136) nach Anspruch 1, ferner umfassend ein Schnittstellenmodul (324, 1124), das dazu konfiguriert ist, Identifikationsinformationen einer zu testenden Fahrzeugkomponente zu empfangen.

7. Diagnosewerkzeug (336, 1136) nach Anspruch 6, wobei das Schnittstellenmodul (324, 1124) dazu konfiguriert ist, die Identifikationsinformationen von einem Strichcodelesegerät, einem RFID-Lesegerät oder einer Verkaufsstelle (Point-Of-Sale, POS) zu empfangen.

8. Diagnosewerkzeug (336, 1136) nach Anspruch 1, wobei die Testinformationen zumindest eines der folgenden Elemente beinhalten: Testspezifikation, Testwerte, Testergebnisse, Daten, Zeit, Mitarbeiter, Ort und Wetterbedingungen.

9. Diagnosewerkzeug (336, 1136) nach Anspruch 1, wobei das kapazitive Element (610) mehrere kapazitive Elemente umfasst.

10. Verfahren zum Testen einer Fahrzeugkomponente, umfassend die folgenden Schritte:
Empfangen einer Auswahl der Fahrzeugkomponente zum Testen über eine Eingabevorrichtung;
Identifizieren von der Fahrzeugkomponente zugeordneten Informationen über ein Schnittstellenmodul (324, 1124);
Laden eines kapazitiven Elements (610) über ein Lademodul (334) zumindest teilweise auf der Grundlage von der Fahrzeugkomponente zugeordneten Informationen, um den Test der Fahrzeugkomponente auszuführen, **gekennzeichnet durch**
das Steuern eines Zeitpunkts und einer dem kapazitiven Element (610) bereitgestellten Ladungsmenge über das Lademodul (334),
wobei das Lademodul (334) das kapazitive Element (610) zumindest teilweise auf der Grundlage einer zum Ausführen des Tests der Fahrzeugkomponente erforderlichen Leistungsmenge lädt.

11. Verfahren nach Anspruch 10, wobei das Identifizieren von der Fahrzeugkomponente zugeordneten Informationen das Identifizieren eines Leistungsniveaus umfasst, auf dem die Fahrzeugkomponente getestet werden soll.

12. Verfahren nach Anspruch 10, wobei das Laden des kapazitiven Elements (610) das Laden des kapazitiven Elements (610) vor dem Ausführen des Tests der Fahrzeugkomponente umfasst.

13. Verfahren nach Anspruch 10, wobei das Laden des kapazitiven Elements (610) das Laden des kapazitiven Elements (610) während des Tests der Fahrzeugkomponente umfasst.

## Revendications

1. Outil de diagnostic (336, 1136) conçu pour tester la performance d'un composant de véhicule, l'outil de diagnostic (336, 1136) comprenant :
un processeur (304, 1104) conçu pour traiter les informations de test provenant du composant de véhicule et commander le composant de véhicule à tester ;
une mémoire (308, 1110) conçue pour stocker les informations de test du composant de véhicule et le logiciel qui fait fonctionner le composant de véhicule ;
un élément capacitif (610) conçu pour fournir la puissance pour effectuer le test du composant de véhicule,
la mémoire (308, 1110) et l'élément capacitif (610) étant en communication avec le processeur (304, 1104), **caractérisé par**
un module de charge (334) qui commande un temps et une quantité de charge fournis à l'élément capacitif (610),
le module de charge (334) chargeant l'élément capacitif (610) sur la base au moins en partie d'une quantité de puissance nécessaire pour effectuer le test du composant de véhicule.

2. Outil de diagnostic (336, 1136) selon la revendication 1, le composant de véhicule étant un composant de démarreur et le processeur (304, 1104) étant également conçu pour commander le démarreur et traiter les informations de démarreur.

3. Outil de diagnostic (336, 1136) selon la revendication 1, le composant de véhicule étant un alternateur (914, 1210) et le processeur (304, 1104) étant également conçu pour commander l'alternateur (914, 1210) et traiter les informations d'alternateur.

4. Outil de diagnostic (336, 1136) selon la revendication 1, le module de charge (334) chargeant l'élément capacitif (610) avec un potentiel de tension et/ou un courant constant.

5. Outil de diagnostic (336, 1136) selon la revendication 1, le module de charge (334) chargeant l'élément capacitif (610) avec un potentiel de tension et/ou un courant variable.

6. Outil de diagnostic (336, 1136) selon la revendication 1, comprenant en outre un module d'interface (324, 1124) conçu pour recevoir des informations d'identification d'un composant du véhicule à tester.

7. Outil de diagnostic (336, 1136) selon la revendication 6, le module d'interface (324, 1124) étant conçu pour recevoir les informations d'identification d'un lecteur de code à barres, d'un lecteur RFID ou d'un point de vente (POS).

8. Outil de diagnostic (336, 1136) selon la revendication 1, les informations de test comprenant au moins un des éléments suivants : spécification de test, valeurs de test, résultats de test, données, heure, employé, lieu et conditions météorologiques.

9. Outil de diagnostic (336, 1136) selon la revendication 1, l'élément capacitif (610) comprenant une pluralité d'éléments capacitifs.

10. Procédé de test d'un composant de véhicule, comprenant les étapes consistant à :
recevoir, par l'intermédiaire d'un dispositif d'entrée, une sélection du composant de véhicule à tester ;
identifier, par l'intermédiaire d'un module d'interface (324, 1124), les informations associées au composant de véhicule ;
charger, par l'intermédiaire d'un module de charge (334), un élément capacitif (610) sur la base au moins en partie des informations associées au composant de véhicule afin d'effectuer le test du composant de véhicule, **caractérisé par** l'étape consistant à
commander, par l'intermédiaire du module de charge (334), un temps et une quantité de charge fournis à l'élément capacitif (610),
le module de charge (334) chargeant l'élément capacitif (610) sur la base au moins en partie d'une quantité de puissance nécessaire pour effectuer le test du composant de véhicule.

11. Procédé selon la revendication 10, l'identification des informations associées au composant de véhicule comprenant l'étape consistant à identifier un niveau de puissance auquel le composant de véhicule doit être testé.

12. Procédé selon la revendication 10, la charge de l'élément capacitif (610) comprenant l'étape consistant à charger l'élément capacitif (610) avant d'effectuer le test du composant de véhicule.

13. Procédé selon la revendication 10, la charge de l'élément capacitif (610) comprenant l'étape consistant à charger l'élément capacitif (610) pendant le test du composant de véhicule.
